# EUROPÄISCHE PATENTSCHRIFT

(11) **EP 3 393 208 B1**
(45) Veröffentlichungstag und Bekanntmachung des Hinweises auf die Patenterteilung: **24.05.2023**
(21) Anmeldenummer: 18167422.7
(22) Anmeldetag: 16.04.2018
(51) Int. Cl.: H05B 47/18

(54) **BELEUCHTUNGSSYSTEM MIT SIGNALGENERATOREN**
ILLUMINATION SYSTEM WITH SIGNAL GENERATORS
SYSTÈME D'ÉCLAIRAGE DOTÉ DES GÉNÉRATEURS DE SIGNAUX

(30) Priorität: 21.04.2017 AT 782017 U
(43) Veröffentlichungstag der Anmeldung: 24.10.2018
(73) Patentinhaber: Tridonic GmbH & Co. KG, 6851 Dornbirn (AT)
(72) Erfinder: Moosmann, Florian, 6835 Muntlix (AT)
(74) Vertreter: Rupp, Christian

(56) Entgegenhaltungen:
- WO-A1-2015/000754
- WO-A1-2015/055759
- WO-A1-2015/165769
- WO-A1-2017/001281
- WO-A2-2015/071232
- DE-A1-102009 051 968
- JP-A- 2001 103 753
- US-A1- 2002 099 451
- US-A1- 2008 276 154
- US-A1- 2012 098 459

## Beschreibung

Die Erfindung betrifft ein Beleuchtungssystem gemäß dem Oberbegriff des Anspruchs 1 und einem Verfahren zum Ansteuern eines Konverters nach Anspruch 5.

### Technisches Gebiet

Betriebsgeräte für Leuchtmittel, wie Vorschaltgeräte oder Konverter, können über Schnittstelle angesteuert werden, insbesondere können Dimmbefehle über die Schnittstelle übertragen werden, um die Helligkeit der Leuchtmittel einzustellen. Die Dimmbefehle werden oftmals anhand des DALI (digital adressable lighting interface) Protokolls an die Schnittstelle übertragen. Diese Schnittstellen sind i. d. R. drahtgebunden ausgeführt. Steuergeräte erzeugen dabei die Dimmbefehle und übertragen diese über über Steuerleitungen an die jeweiligen Konverter. Steuerleitungen können durch Effekte wie Korrission, Verschmutzung, Alterung, mechanische oder andere physikalische so beeinflusst werden, dass die Signale bei der Übertragung so stark elektrisch gedämpft werden, dass es zu Beeinträchtigungen der Steuerfunktionen kommen kann.

### Stand der Technik

Es können zwar Fehlsignalübertragungen erkannt werden, es kann aber nicht ermittelt werden ob die Steuerleitungen defekt sind und insbesondere welche Steuerleitung defekt ist. Aufgrund dessen wird recht häufig sämtliche Steuergeräte ausgetauscht, anstatt die relativ kostengünstige defekte Steuerleitung zu tauschen. Dies verursacht recht hohe Kosten.

Die Druckschrift US 2008/276154 A1 offenbart ein digitales Beleuchtungssteuerungs-Netzwerkprotokoll mit Vorwärts- und Rückwärtsrahmen, wobei jeder Rahmen einen Fehlerprüfcode enthält. Ein Nichtbestätigungssignal (NAK-Signal) wird als Reaktion auf den Fehlerprüfcode von einem Empfangsknoten zu einem Sendeknoten gesendet.

Die Druckschrift US 2002/099451 offenbart eine verbesserte Technik zum Verbinden einer

Computerbeleuchtungsvorrichtung mit einem Steuercomputer, wobei eine Hardwarevorrichtung zwischen dem Steuercomputer und der Beleuchtungsvorrichtung angeordnet ist.

Die Druckschrift WO 2015/165769 offenbart eine Sicherheitsschutzanordnung, welche für eine Beleuchtungsanordnung vorgesehen ist. Mit dem Ansteuern der Beleuchtungsanordnung mit bestimmten Ansteuereinstellungen wird ein elektrischer Parameter gemessen und mit einem geschätzten erwarteten Wert des elektrischen Parameters verglichen, so dass bei einem erkannten Systemausfall ein Sicherheitswarnsignal oder eine Abschaltung bereitgestellt werden kann.

Die Druckschrift WO 2015/055759 offenbart eine Zentraleinheit, die eine Leuchtmittelbedienvorrichtung für ein Leuchtmittel, vorzugsweise ein LED-Modul, mittels eines DC-Busses versorgt. Die Leuchtmittelbedienvorrichtung weist einen Sensor auf. Die Zentraleinheit erzeugt eine Versorgungsgleichspannung zur Versorgung der Leuchtmittelbedienvorrichtung.

Die Druckschrift WO 2015/071232 offenbart Vorrichtungen zum Erkennen von Problemen in Kabelsystemen, die Kabel und Lasten umfassen, sind mit Injektoren zum Injizieren erster Untersuchungssignale in die Kabel, Empfänger zum Empfangen erster Reflexionssignale, die erste Reflexionen der ersten Untersuchungssignale von den Kabeln umfassen, und Prozessoren versehen.

Es besteht daher ein Bedarf an Vorrichtungen, Systemen und Verfahren, die ein vereinfachtes Erkennen von defekten Steuerleitungen ermöglicht und im Weiteren bei einer Vielzahl von Konvertern erkennt welche Steuerleitung defekt ist.

Nach Ausführungsbeispielen wird vorgesehen, dass ein Beleuchtungssystem ein selbstständiges Erkennen von defekten Steuerleitungen durchführt.

Die vorliegende Erfindung stellt daher ein System und ein Verfahren bereit, die dieser Situation Rechnung trägt und die Kosten und die Zeit für den Austausch von Steuergeräten senkt.

### Darstellung der Erfindung

Es ist die Aufgabe der vorliegenden Erfindung, ein gegenüber dem Stand der Technik verbessertes Beleuchtungssystem bereitzustellen, welche auf einfache Art und Weise ein vereinfachtes Erkennen von defekten Steuerleitungen ermöglicht und im Weiteren bei einer Vielzahl von Konvertern erkennt welche Steuerleitung defekt ist.

Diese Aufgabe wird erfindungsgemäß durch die Merkmale der unabhängigen Ansprüche gelöst. Die abhängigen Ansprüche bilden den zentralen Gedanken der Erfindung in besonders vorteilhafter Weise weiter.

Die Erfindung wird nunmehr auch mit Bezug auf die Figur beschrieben. Dabei zeigt

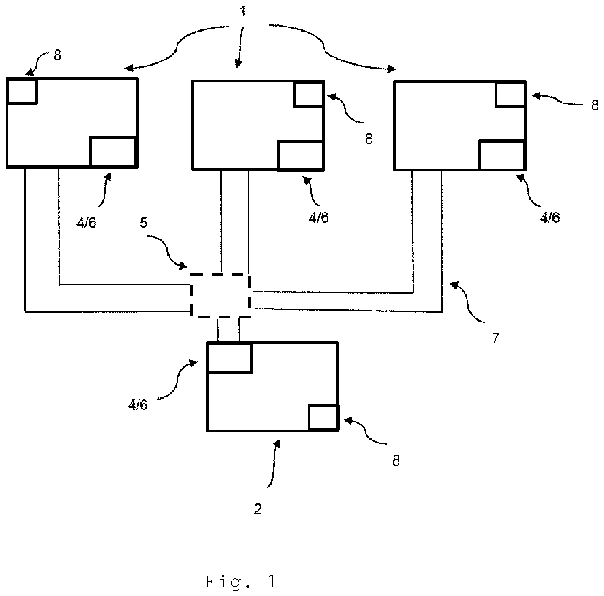

Fig. 1 eine Ausgestaltung des erfindungsgemäßen Beleuchtungssystems.

Gemäß Fig. 1 wird ein Beleuchtungssystem bereitgestellt, mit mindestens einem Leuchtmittel, insbesondere einer LED, aufweisend: mindestens einen Konverter 1 zur Steuerung des mindestens einen Leuchtmittels, mindestens ein Steuergerät 2 oder mindestens ein zentrales Steuergerät 2, Steuerleitungen 7 zum Verbinden des Konverters 1 mit dem Steuergerät 2
wobei, das mindestens eine Steuergerät 2 oder mindestens eine zentrale Steuergerät 2 einen Signalgenerator 6 aufweist und mittels des Signalgenerators 6 ein Referenzsignal generiert und über die Steuerleitungen 7 an den Konverter 1 übermittelt und eine Auswerteeinheit 4 das Referenzsignal erfasst und auswertet.

Die Steuerleitungen können eine Schnittstelle des Konverters 1 mit einer Schnittstelle des Steuergeräts 2 verbinden.

Das Referenzsignal kann ein AC, DC oder ein kombiniertes AC-DC Signal sein. Dabei kann das Referenzsignal rechteckig, dreieckig, sägezahnförmig, trapezförmig, usw. sein.

Die Auswerteeinheit 4 wertet den arithmetischen Durchschnitt des Referenzsignals aus und vergleicht den arithmetischen Durchschnitt mit in einem Speicher 8 hinterlegten Grenzwerten. Gemäß einer nicht erfindungsgemäßen Ausführungsform kann die Auswerteeinheit 4 die Amplitude, die Frequenz oder den RMS des Referenzsignals auswerten und mit in einem Speicher 8 hinterlegten Grenzwerten vergleichen. Die Grenzwerte im Speicher 8 können bei der Herstellung der Konverter 1 oder der Steuergeräte 2 programmiert werden oder später von einem Benutzer geändert werden. Eine Änderung der Grenzwerte durch einen Benutzer könnte vor allem dann stattfinden wenn ein anderes neues Referenzsignal vom Signalgenerator 6 erzeugt werden würde.

Die Auswerteeinheit 4 kann das Ergebnis des Vergleiches des Referenzsignales mit hinterlegten Grenzwerten an das Steuergerät 2 über die Steuerleitung 7 übermitteln. Wenn die Steuerleitung 7 eine Beeinträchtigung aufweisen würde, bei der der Vergleich des Referenzsignales mit den Grenzwerten außerhalb der Grenzwerte liegen würde, interpretiert der Konverter 1 den Vergleich als fehlerhaft und signalisiert, dass die Steuerleitung defekt ist. Gemäß einer nicht erfindungsgemäßen Ausführungsform würde, wenn die Steuerleitung 7 eine Beeinträchtigung aufweisen würde, bei der der Vergleich des Referenzsignales mit den Grenzwerten außerhalb der Grenzwerte liegen würde, das Steuergerät 2 den Vergleich als fehlerhaft interpretieren und signalisieren, dass die Steuerleitung defekt ist. Die Signalisierung kann dabei akustisch, optisch über das mindestens eine Leuchtmittel, drahtlos über Funk, Infrarot usw. vom Konverter 1 oder Steuergerät 2 erfolgen. Insbesondere könnte das Steuergerät 2 eine drahtlos Rückmeldung an einen Benutzer durchführen. Die Rückmeldung könnte dabei auf ein mobiles Gerät wie beispielsweise ein smartphone erfolgen.

Wenn die Beschädigung der Steuerleitung 7 so groß ist, dass eine Rückmeldung des Konverters 1 oder des Steuergerätes 2 nicht möglich ist, würde aufgrund der fehlenden Rückmeldung der Konverter 1 oder das Steuergerät 2 den Fehler signalisieren.

Das Ergebnis des Vergleiches des Referenzsignales mit den hinterlegten Grenzwerten kann eine Adressinformation oder Positionsinformation des jeweiligen Konverters 1 oder des Steuergerätes 2 beinhalten. Positionsinformationen können GPS Koordinaten, Rauminformationen o. ä. sein. Durch diese Positionsinformation erhält der Benutzer die Kenntnis welche Steuerleitungen bei einer Beeinträchtigung getauscht werden müsste.

Die Auswerteeinheit 4 ist im Konverter 1 angeordnet und der Signalgenerator 6 ist im Steuergerät 2 angeordnet.

Gemäß einer nicht erfindungsgemäßen Ausführungsform kann die Auswerteeinheit 4 im Steuergerät 2 angeordnet sein und der Signalgenerator 6 kann im Konverter 1 angeordnet sein.

Gemäß einer nicht erfindungsgemäßen Ausführungsform kann der Signalgenerator 6 und/oder die Auswerteeinheit 4 in einem externen Modul 5 angeordnet sein. Das externe Modul 5 kann dabei mit sämtlichen Konverter 1 und sämtlichen Steuergeräte 2 mittels der

Steuerleitungen 7 verbunden sein. Das externe Modul 5 kann dem Steuergerät 2 mitteilen welche Steuerleitungen 7 defekt sind und das Steuergerät 2 kann den Fehler signalisieren.

Das Steuergerät 2 generiert mittels des Signalgenerators 6 ein Referenzsignal und übermittelt es über die Steuerleitung 7 an den Konverter 1 und kann die Signalreflexionen zwischen dem Steuergerät 2 und dem Konverter 1 auswerten. Gemäß einer nicht erfindungsgemäßen Ausführungsform kann der Konverter 1 mittels des Signalgenerators 6 ein Referenzsignal generieren und über die Steuerleitung 7 an das Steuergerät 2 übermitteln und die Signalreflexionen zwischen dem Steuergerät 2 und dem Konverter 1 auswerten. Das reflektierte Signal könnte mit einem Speicher 8 hinterlegten Grenzwerten verglichen werden.

Des Weiteren wird ein Verfahren zum Ansteuern eines Konverters 1 offenbart bei dem ein Steuergerät 2 ein Referenzsignal generiert mittels einem Signalgenerator 6 und das Referenzsignal
über Steuerleitungen 7 an einen Konverter 1 übermittelt wird, wobei der Konverter 1 das Referenzsignal mit in einem Speicher 8 hinterlegten Grenzwerten vergleicht und das Ergebnis der Überprüfung an das Steuergerät 2 übermittelt.

Der Vergleich des Referenzsignals mit in einem Speicher 8 hinterlegten Grenzwerten kann auf einen Steuerbefehl oder bei Erstinbetriebnahme des Beleuchtungssystems erfolgen. Der Steuerbefehl kann von einem Benutzer ausgelöst werden.

## Patentansprüche

1. Beleuchtungssystem mit mindestens einem Leuchtmittel, insbesondere einer LED, aufweisend:
a) mindestens einen Konverter (1) zur Steuerung des mindestens einen Leuchtmittels, wobei der Konverter (1) eine Auswerteeinheit (4) umfasst;
b) mindestens ein Steuergerät (2) oder mindestens ein zentrales Steuergerät (2);
c) Steuerleitungen (7) zum Verbinden des Konverters (1) mit dem Steuergerät (2);
**dadurch gekennzeichnet, dass** das mindestens eine Steuergerät (2) oder mindestens eine zentrale Steuergerät (2) einen Signalgenerator (6) aufweist und mittels des Signalgenerators (6) ein Referenzsignal generiert und über die Steuerleitungen (7) an den Konverter (1) übermittelt und die Auswerteeinheit (4) ausgebildet ist, das Referenzsignal zu erfassen, einen arithmetischen Durchschnitt des Referenzsignals auszuwerten, und mit in einem Speicher (8) hinterlegten Grenzwerten zu vergleichen, wobei der Konverter (1) ferner ausgebildet ist, die Steuerleitungen (7) als defekt zu signalisieren, falls ein Ergebnis des Vergleichs des arithmetischen Durchschnitts des Referenzsignals mit den Grenzwerten außerhalb der Grenzwerte liegt.

2. Beleuchtungssystem nach Anspruch 1,
**dadurch gekennzeichnet,**
**dass** das Referenzsignal ein AC, DC oder ein kombiniertes AC-DC Signal ist.

3. Beleuchtungssystem nach Anspruch 1,
**dadurch gekennzeichnet,**
**dass** die Auswerteeinheit (4) das Ergebnis des Vergleiches des Referenzsignales mit hinterlegten Grenzwerten an das Steuergerät (2) übermittelt.

4. Beleuchtungssystem nach Anspruch 3, **dadurch gekennzeichnet,**
**dass** das Ergebnis des Vergleiches des Referenzsignales mit den hinterlegten Grenzwerten eine Adressinformation oder Positionsinformation des jeweiligen Konverters (1) beinhaltet.

5. Verfahren zum Ansteuern eines Konverters (1) eines Beleuchtungssystems nach einem der Ansprüche 1 bis 4, mit folgenden Schritten:
a) Generieren eines Referenzsignals mit einem Signalgenerator (6) eines Steuergerätes (2)
b) Übermitteln des Referenzsignals über Steuerleitungen (7) an den Konverter (1) **gekennzeichnet durch das:**
Erfassen des Referenzsignals vom Konverter (1);
Auswerten eines arithmetischen Durchschnitts des Referenzsignals;
Vergleichen des ausgewerteten arithmetischen Durchschnitts mit in einem Speicher (8) hinterlegten Grenzwerten;
Signalisieren der Steuerleitungen (7) als defekt, falls ein Ergebnis des Vergleichs des arithmetischen Durchschnitts des Referenzsignals mit den Grenzwerten außerhalb der Grenzwerte liegt; und
Übermitteln des Ergebnisses des Signalisierens an das Steuergerät (2).

6. Verfahren nach Anspruch 5
**dadurch gekennzeichnet,**
**dass** das Vergleichen des arithmetischen Durchschnitts des Referenzsignals mit dem im Speicher (8) hinterlegten Grenzwert auf einen Steuerbefehl oder bei Erstinbetriebnahme erfolgt.

## Claims

1. Illumination system having at least one luminaire, in particular an LED, comprising:
a) at least one converter (1) for controlling the at least one luminaire, the converter (1) comprising an evaluation unit (4);
b) at least one control device (2) or at least one central control device (2);
c) control lines (7) for connecting the converter (1) to the control device (2);
**characterized in that** the at least one control device (2) or at least one central control device (2) comprises a signal generator (6) and a reference signal is generated by means of the signal generator (6) and transmitted via the control lines (7) to the converter (1), and the evaluation unit (4) is designed to detect the reference signal, to evaluate an arithmetic average of the reference signal, and to compare it with limit values stored in a memory (8), the converter (1) further being designed to signal the control lines (7) as defective if a result of the comparison of the arithmetic average of the reference signal with the limit values is outside the limit values.

2. Illumination system according to claim 1,
**characterized in that**
the reference signal is an AC, DC, or a combined AC-DC signal.

3. Illumination system according to claim 1,
**characterized in that**
the evaluation unit (4) transmits the result of the comparison of the reference signal with stored limit values to the control device (2).

4. Illumination system according to claim 3, **characterized in that**
the result of the comparison of the reference signal with the stored limit values includes address information or position information of the relevant converter (1).

5. Method for controlling a converter (1) of an illumination system according to any of claims 1 to 4, comprising the following steps:
a) generating a reference signal using a signal generator (6) of a control unit (2);
b) transmitting the reference signal via control lines (7) to the converter (1);
**characterized by:**
detecting the reference signal by means of the converter (1);
evaluating an arithmetic average of the reference signal;
comparing the evaluated arithmetic average with limit values stored in a memory (8);
signaling the control lines (7) as defective if a result of the comparison of the arithmetic average of the reference signal with the limit values is outside the limit values; and
transmitting the result of the signaling to the control device (2).

6. Method according to claim 5,
**characterized in that**
the arithmetic average of the reference signal is compared with the limit value stored in the memory (8) in response to a control command or during initial start-up.

## Revendications

1. Système d'éclairage comportant au moins un moyen lumineux, en particulier une DEL, présentant :
a) au moins un convertisseur (1) pour la commande de l'au moins un moyen lumineux, le convertisseur (1) comprenant une unité d'évaluation (4) ;
b) au moins un appareil de commande (2) ou au moins un appareil de commande (2) central ;
c) des lignes de commande (7) pour la connexion du convertisseur (1) à l'appareil de commande (2) ;
**caractérisé en ce que** l'au moins un appareil de commande (2) ou au moins un appareil de commande (2) central présente un générateur de signaux (6) et un signal de référence est généré au moyen du générateur de signaux (6) et transmis au convertisseur (1) par l'intermédiaire des lignes de commande (7) et l'unité d'évaluation (4) est configurée pour détecter le signal de référence, pour évaluer une moyenne arithmétique du signal de référence et pour la comparer avec des valeurs limites enregistrées dans une mémoire (8), le convertisseur (1) étant en outre configuré pour signaler les lignes de commande (7) comme défectueuses si un résultat de la comparaison de la moyenne arithmétique du signal de référence avec les valeurs limites se situe en dehors des valeurs limites.

2. Système d'éclairage selon la revendication 1,
**caractérisé en ce**
**que** le signal de référence est un signal CA, CC ou un signal CA-CC combiné.

3. Système d'éclairage selon la revendication 1,
**caractérisé en ce**
**que** l'unité d'évaluation (4) transmet le résultat de la comparaison du signal de référence avec des valeurs limites enregistrées à l'appareil de commande (2).

4. Système d'éclairage selon la revendication 3, **caractérisé en ce**
**que** le résultat de la comparaison du signal de référence avec les valeurs limites enregistrées contient des informations d'adresse ou des informations de position du convertisseur (1) respectif.

5. Procédé permettant la commande d'un convertisseur (1) d'un système d'éclairage selon l'une des revendications 1 à 4, comportant les étapes suivantes :
a) génération d'un signal de référence avec un générateur de signaux (6) d'un appareil de commande (2)
b) transmission du signal de référence au convertisseur (1) par l'intermédiaire de lignes de commande (7)
**caractérisé par** :
la détection du signal de référence par le convertisseur (1) ;
l'évaluation d'une moyenne arithmétique du signal de référence ;
la comparaison de la moyenne arithmétique évaluée avec des valeurs limites enregistrées dans une mémoire (8) ;
la signalisation des lignes de commande (7) comme défectueuses si un résultat de la comparaison de la moyenne arithmétique du signal de référence avec les valeurs limites se situe en dehors des valeurs limites ; et
la transmission du résultat de la signalisation à l'appareil de commande (2).

6. Procédé selon la revendication 5
**caractérisé en ce**
**que** la comparaison de la moyenne arithmétique du signal de référence avec la valeur limite enregistrée dans la mémoire (8) s'effectue suite à une instruction de commande ou lors de la première mise en service.
